# DEMANDE DE BREVET EUROPEEN

(11) **EP 0 989 682 A1**
(43) Date de publication de la demande: **29.03.2000**
(21) Numéro de dépôt: 99402292.9
(22) Date de dépôt: 20.09.1999
(51) Int. Cl.: H04B 1/18, H03H 7/12

(54) **Emetteur récepteur de téléphonie mobile**

(30) Priorité: 23.09.1998 FR 9812061
(71) Demandeur: SAGEM SA, 75783 Paris Cédex 16 (FR)
(72) Inventeur: Romao, M. Fernando, Domililié Cabinet C. Schmit, 95000 cergy (FR)
(74) Mandataire: Schmit, Christian Norbert Marie

(57) **Abrégé**

Pour rendre un téléphone mobile adaptable à différentes normes, on prévoit qu'un filtre (1) sélectif haute fréquence relié en émission ou en réception à un aérien (4) puisse être adapté par modification des réactances (5-8) de ses éléments. Les modifications correspondent à des présélections réglées en usine. Dans une solution préférée, les réactances comportent des diodes (12) à capacité variable polarisées (16, 19) en inverse par un circuit de polarisation comportant une mémoire non volatile (22), un microprocesseur (20) et un convertisseur (18) analogique numérique.

## Description

La présente invention a pour objet un émetteur récepteur de téléphonie mobile. Le but de l'invention est de perfectionner les téléphones mobiles et/ou les stations de base pour qu'ils puissent être utilisés indifféremment dans un pays ou dans un autre, avec les services d'un opérateur téléphonique ou d'un autre et ceci tout au long de la durée de vie du téléphone mobile ou de la station de base, même si ces modes d'utilisation changent.

Dans le domaine de la téléphonie mobile on connaît les normes dites GSM, DCS, PCS et maintenant UMTS. D'autres normes sont en rigueur dans d'autres pays ou en préparation. Ces normes se caractérisent essentiellement par la gamme de fréquence dans laquelle doivent fonctionner en émission et en réception les téléphones mobiles concernés. Pour les cas cités, ces gammes de fréquence porteuse sont respectivement 900 MHz, 1 800 MHz, 1 900 MHz et 2 200 MHz.

La réalisation d'un téléphone mobile nécessite le réglage, dans le circuit d'émission et de réception, d'un filtre très sélectif centré sur ces fréquences d'utilisation. Ce réglage est très délicat. Il est effectué au laboratoire et en usine. Dans la pratique les filtres utilisés sont des filtres à onde de surface, ou des filtres avec des capacités fixes. L'appareil étant destiné à un usage particulier, parce que notamment il est vendu dans un pays donné, ou parce qu'il est mis à la disposition des utilisateurs par un opérateur donné, ces filtres sont calculés une fois pour toutes et mis en place dans les téléphones mobiles.

Cette manière de faire présente comme inconvénient pour l'acquéreur qu'il est obligé de rester en relation contractuelle avec un même fournisseur s'il ne veut pas avoir à acquérir un nouvel appareil à chaque changement.

Pour rendre les appareils universels et leur permettre de trafiquer sur les différentes bandes de fréquence, il a été prévu de réaliser autant de filtres sélectifs différents que de bandes de fréquences envisageables. On commute alors les utilisations de ces filtres en fonction des besoins. Mais cette solution présente deux inconvénients. D'une part elle grève le coût du téléphone mobile au prorata du nombre de ces filtres. D'autre part, elle les rend inadaptables aux normes futures, non encore connues. Dans l'invention on ne réalise qu'un seul filtre mais des valeurs retenues pour la réalisation de ses composants peuvent être modifiées en fonction du besoin. La modification est obtenue par des activateurs qui vont faire fonctionner ces composants dans des conditions telles que leurs réactances sont changées.

Dans l'invention, on a constaté en effet que la fréquence centrale de ces bandes de fréquence, tout en étant différente présentait cependant entre elles de faibles écarts. Ceci est tout à fait justifié pour les bandes DCS, PCS et UMTS, et dans une moindre mesure pour la gamme du GSM 900 MHz. Dans ces conditions il est apparu qu'il était possible d'accorder ces filtres sélectifs avec des valeurs de réactance tout à fait compatible avec un réglage à faible dynamique. En effet, s'agissant notamment des trois bandes de fréquence DCS, PCS et UMTS, l'architecture des filtres peut être conservée, mais les valeurs de leurs éléments légèrement modifiées, pour qu'ils puissent s'adapter aux trois bandes de fréquence possible (ou à d'autres bandes de fréquences proches à définir).

Dans l'invention, on prévoit donc un tel réglage. Dans une solution préférée ce réglage emprunte des valeurs numériques mémorisées dans une mémoire. La programmation ultérieure de la mémoire rend l'adaptation future aisée.

L'invention a donc pour objet un émetteur récepteur de téléphonie mobile comportant un filtre passe bande sélectif centré sur une bande de haute fréquence émise ou reçue, caractérisé en ce que le filtre comporte un jeu de réactances reliées à des activateurs pour modifier le filtre et adapter sa bande à une bande haute fréquence présélectionnée, et un microprocesseur pour commander les activateurs.

L'invention sera mieux comprise à la lecture de la description qui suit et à l'examen des figures qui l'accompagnent. Celles-ci ne sont données qu'à titre indicatif et nullement limitatif de l'invention. Les figures montrent :
- Figure 1 : la représentation schématique d'un émetteur récepteur comportant un filtre passe bande très sélectif selon l'invention ;
- Figure 2 : un diagramme de surtension d'une réactance variable utilisable dans l'invention.

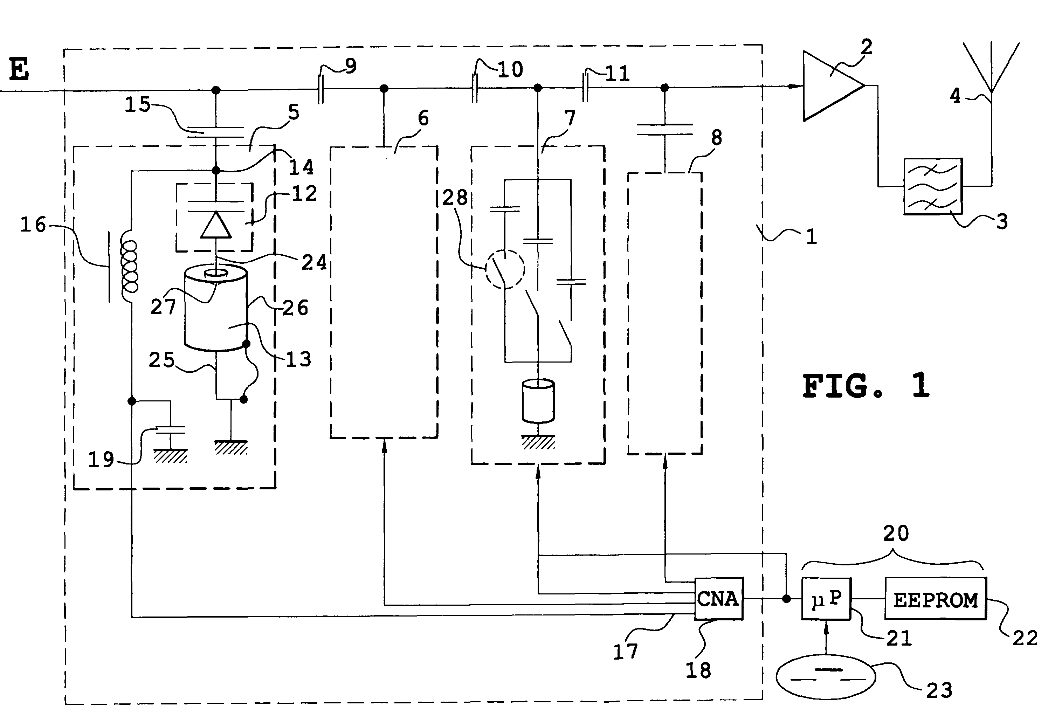

La figure 1 représente un émetteur récepteur de téléphonie mobile selon l'invention. La figure 1 montre en fait uniquement la partie émission. Un duplexeur pourrait par ailleurs permettre de faire fonctionner la chaîne représentée à l'envers, en réception. La chaîne d'émission montrée comporte un filtre 1 passe bande très sélectif et centré sur une bande de haute fréquence. Le filtre 1 reçoit en entrée E un signal à filtrer et le transmet à sa sortie S à un amplificateur d'émission 2. L'amplificateur 2 peut lui-même être relié à un deuxième filtre 3 du même type que le premier pour parfaire la sélectivité. Le filtre 3 qui élimine les distorsions de l'amplificateur 2 peut de préférence subir un traitement d'adaptation selon l'invention similaire au traitement d'adaptation subi par le filtre 1. En réception, les filtres 1 et 3 sont remplacés par un seul filtre qui subira également de préférence les adaptations de l'invention. Le filtre 3 est relié à un aérien 4 d'émission.

Compte tenu de la sélectivité recherchée, le filtre 1 est un filtre du cinquième ordre mais il pourrait avoir un ordre supérieur ou inférieur en fonction du besoin. Le filtre 1 montré est un filtre en π. Il comporte dans cet exemple des réactances 5 à 8 reliées entre elles par l'intermédiaire de condensateurs 9 à 11. Les réactances 5 à 8 sont en parallèles les unes des autres. Elles sont reliées à la masse par une de leurs extrémités. L'entrée E et la sortie S du filtre 1 sont reliées respectivement aux condensateurs 9 et 11. Les réactances 5 à 8 possèdent selon l'invention la particularité d'avoir une valeur de réactance modifiable.

Dans un exemple, la réactance 5 est constituée par une diode 12 à capacité variable de type VARICAP en série avec un résonateur diélectrique 13. Dans un exemple, ce résonateur diélectrique est un tronçon de câble coaxial. La cathode 14 de la diode VARICAP 12 est relié à une bome d'un condensateur de couplage 15. L'autre borne du condensateur 15 est reliée à l'entrée E. Dans un exemple, le condensateur de couplage 15 est un très gros condensateur et n'influe pas (puisqu'il est en série avec la capacité de la diode 12) sur la sélectivité du filtre. La cathode 14 est par ailleurs reliée par une inductance de choc 16 à une sortie 17 d'un convertisseur numérique analogique 18. La sortie 17 est également relié à la masse par l'intermédiaire d'un condensateur de découplage 19. Le condensateur 19 et l'inductance de choc 16 servent à transmettre une composante continue disponible à la sortie 17 sur la cathode 14, tout en évitant la transmission du signal haute fréquence disponible à l'entrée E du filtre 1 dans le convertisseur 18. Le condensateur 15 permet l'action de filtrage de la réactance 5 sur le signal alternatif haute fréquence de l'entrée E tout en empêchant la transmission de la composante continue par la sortie 17.

Le convertisseur 18 est relié à une unité centrale de traitement 20 comportant notamment un microprocesseur 21 et une mémoire non volatile 22. La mémoire 22, de préférence de type EEPROM, comprend à la fois un programme à mettre en oeuvre par le microprocesseur 21 ainsi que des valeurs préenregistrées correspondant au réglage du filtre 1. Pour la sélection d'une fréquence centrale sélective du filtre 1, on transmet au microprocesseur 21 une commande provenant d'un organe de commande 23. Par exemple, l'organe de commande 23 est un interrupteur. L'organe 23 peut être néanmoins un dispositif de détection automatique d'un signal apparent sur l'antenne 4 (en réception). Eventuellement l'organe 23 est remplacé par une information disponible dans la mémoire 22, du type amovible dans ce cas, et qui comporte en fonction des utilisations prévues des valeurs différentes de réglage du filtre 1.

Dans tous les cas, des valeurs contenues dans la mémoire 22 sont transmises par le microprocesseur 21 au convertisseur numérique analogique 18. Celui-ci les convertit en une ou plusieurs composantes continues appliquées sur la cathode 14 de la réactance 5 et des parties correspondantes des réactances 6 à 8. L'anode 24 de la diode 12 est reliée, à une extrémité du résonateur 13, à l'âme 25 d'un tronçon de câble coaxial. A une autre extrémité du résonateur 13, le blindage 26 et l'âme 25 du résonateur 15 sont reliés ensemble à la masse.

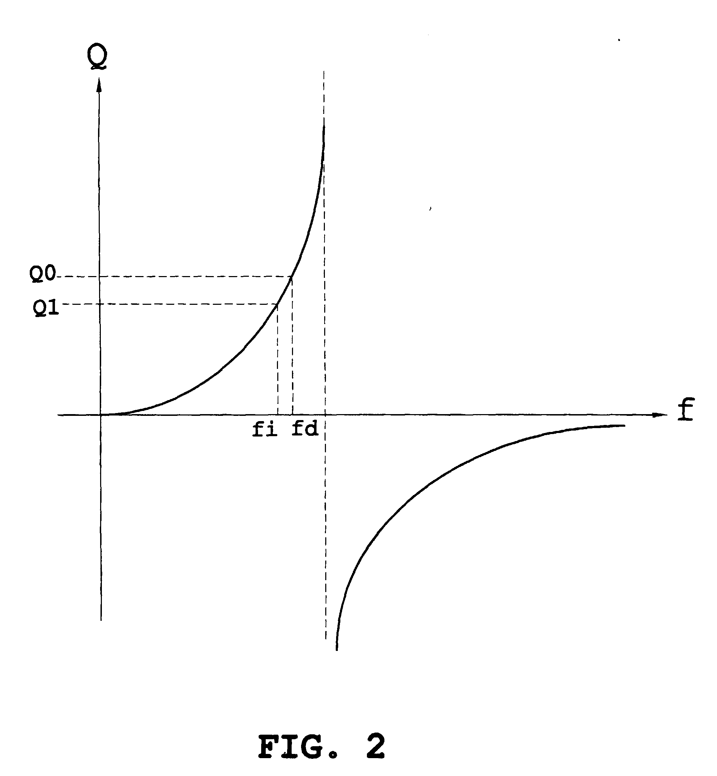

Sur le plan des tensions continues, l'anode 24 est ainsi portée à la masse tandis que la cathode 14 est portée à une tension imposée par le convertisseur numérique analogique 18. Si la tension imposée par le convertisseur 18 est positive, la diode 12 se met en inverse et elle adopte une valeur capacitive imposée par la tension de polarisation. Par exemple pour des tensions variant entre 0 et 5 Volts la capacité de la diode 12 peut varier entre 20 et 60 picofarads. En série avec le résonateur 13, la réactance 5 présente une surtension, montrée sur la figure 2, qui peut être très élevée. Sur cette figure 2 on a montré que pour une fréquence f0 cette surtension pouvait avoir une valeur Q0 valant de l'ordre de 1 000.

Pour le réglage de la gamme de fréquence de résonance du filtre, il existe deux possibilités. Soit on charge dans la mémoire 22 non volatile, gamme par gamme, ou dans des mémoires 22 amovibles différentes selon le cas, des valeurs numériques correspondant à des tensions analogiques à appliquer sur la cathode 14 pour imposer une capacité donnée à la diode 12. De ce fait la réactance 5 résonnera à une fréquence f0 ou à une fréquence fi choisie selon la norme à respecter. Pour un réglage collectif, qui exerce son influence sur toutes les gammes de fréquence, on peut rogner une extrémité 27 de l'âme 26 du résonateur 13. Un tel réglage individuel ou collectif est entrepris pour toutes les réactances du filtre 1. Pour une gamme de fréquence choisie, les réglages des différentes réactances 5 à 8 peuvent être différents. Si le filtre est un filtre en T au lieu d'être un filtre en πΠ comme montré, on pourra avoir besoin de polariser les deux extrémités des réactances avec des découpleurs 16, 19.

Pour les gammes de fréquence envisagées, autant la capacité de la diode 12 doit pouvoir être réglée entre 20 et 60 picofarads, autant des capacités de diodes correspondant à des réactances 6 et 7 doivent pouvoir être réglées entre 6 et 20 picofarads. Dans ce cas, ces dernières peuvent être constituées d'une manière différente. Elles peuvent alors comporter des diodes ou des transistors de type pin. Ces diodes ou ces transistors pin, quand ils sont passants, présentent à la fois une résistance faible, une inductance faible et une capacité sensible. Lorsqu'ils sont bloqués, ils présentent une capacité très faible en plus du fait qu'ils sont en circuit ouvert. On peut alors relier et mettre en service un ou plusieurs de ces diodes ou transistors pin, montés en parallèle en batterie. Chacun d'eux se présente comme un condensateur en série avec un interrupteur 28 de commande. Dans ce cas, il n'est pas nécessaire de disposer du convertisseur 18. Il suffit d'attaquer directement chacun des composants de cette batterie par un signal produit par le microprocesseur 21.

Les valeurs accessibles par des diodes ou des transistors de type pin sont de l'ordre de 2 à 4 picofarads. Il suffit d'en mettre trois en parallèle pour proposer un condensateur dont la valeur peut être 0, 2, 4 ou 6 picofarads ou 0, 4, 8 ou 12 picofarads. Dans le cas où on aurait affaire à des diodes pin, on les polariserait d'une manière similaire aux diodes 12. Dans le cas où on aurait affaire à des transistors pin, on les polariserait à des tensions fixes et on les commanderait selon le besoin.

Autant les diodes 12 ont globalement un comportement capacitif, autant les diodes ou transistors pin pourront avoir un comportement inductif. En conséquence, on adaptera les longueurs des résonateurs diélectriques 13 pour que le court-circuit de sortie ramené à l'entrée soit équivalent à une inductance de valeur voulue. Selon l'invention les réglages, les contenus d'information de la mémoire 22, seront déterminés en usine ou au laboratoire.

## Revendications

1. Emetteur (2) ou récepteur de téléphonie mobile comportant un filtre (1) passe bande sélectif centré sur une bande (f0) de haute fréquence émise ou reçue, caractérisé en ce que le filtre comporte un jeu (5-8) de réactances variables (12) reliées à des activateurs (18, 20 à 22) pour modifier le filtre et adapter (Q0) sa bande à une bande haute fréquence présélectionnée, et un microprocesseur (21) pour commander les activateurs et en ce qu'une réactance comporte un résonateur (13) diélectrique.

2. Emetteur ou récepteur selon la revendication 1, caractérisé en ce que les réactances comportent des diodes (12) à capacité variable en série chacune avec un résonateur (13) diélectrique et en ce que les activateurs comportent un circuit (16, 19) de polarisation des cathodes de ces diodes.

3. Emetteur ou récepteur selon l'une des revendications 1 à 2, caractérisé en ce que les réactances comportent des diodes pin ou des transistors pin, et en ce que les activateurs comportent un circuit de polarisation des anodes de ces diodes pin ou transistors pin.

4. Emetteur ou récepteur selon l'une des revendications 2 à 3, caractérisé en ce que le circuit de polarisation comporte reliés entre eux une mémoire non volatile (22), une unité (21) centrale de traitement, un convertisseur (18) analogique numérique, et un circuit (16, 19) d'isolation de la haute fréquence.
